(19) Europäisches Patentamt / European Patent Office / Office européen des brevets

(11) EP 3 171 447 A1

(12) **EUROPEAN PATENT APPLICATION**
published in accordance with Art. 153(4) EPC

(43) Date of publication:
24.05.2017 Bulletin 2017/21

(51) Int Cl.:
*H01M 10/48* (2006.01)   *G01R 31/36* (2006.01)

(21) Application number: 15821931.1

(86) International application number:
PCT/JP2015/061351

(22) Date of filing: 13.04.2015

(87) International publication number:
WO 2016/009687 (21.01.2016 Gazette 2016/03)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA

(30) Priority: 18.07.2014 JP 2014148341

(71) Applicant: Kabushiki Kaisha Toshiba
Minato-ku
Tokyo 105-8001 (JP)

(72) Inventors:
• MATSUOKA Makoto
  Tokyo 105-8001 (JP)

• KOSUGI Shinichiro
  Tokyo 105-8001 (JP)
• UCHIDA Katsuya
  Tokyo 105-8001 (JP)
• KURODA Kazuto
  Tokyo 105-8001 (JP)
• SEKINO Masahiro
  Tokyo 105-8001 (JP)
• KANEKO Norihiro
  Tokyo 105-8001 (JP)

(74) Representative: Awapatent AB
Junkersgatan 1
582 35 Linköping (SE)

(54) **BATTERY PACK SYSTEM AND BATTERY PACK CONTROL BOARD**

(57) A battery assembly system of an embodiment includes: a battery assembly; a temperature measuring part; and a monitoring device. The battery assembly includes a plurality of batteries connected in series. The temperature measuring part measures temperatures of connection parts used to connect electrodes of batteries included in the battery assembly. The monitoring device derives temperatures of the batteries on the basis of the temperatures measured by the temperature measuring part.

FIG. 1

**Description**

[Technical Field]

An embodiment of the present invention relates to a battery assembly system and a control board for a battery assembly.

[Background Art]

In the related art, a battery assembly in which a plurality of batteries are connected is known. It is important in deriving states of the batteries to ascertain temperatures of the batteries constituting the battery assembly. However, directly or indirectly, it is difficult to measure the temperatures of the batteries constituting the battery assembly. Also, in the related art, the temperatures of the batteries cannot be appropriately derived on the basis of the temperatures, which are indirectly measured, in some cases.

[Citation List]

[Patent Literature]

[Patent Literature 1] Japanese Unexamined Patent Application, First Publication No. 2010-220323

[Summary of Invention]

[Technical Problem]

An object to be accomplished by the present invention is to provide a battery assembly system and a control board of a battery assembly which can derive temperatures of batteries constituting a battery assembly.

[Solution to Problem]

A battery assembly system of an embodiment includes: a battery assembly; a temperature measuring part; and a monitorer. The battery assembly includes a plurality of batteries connected in series. The temperature measuring part measures temperatures of connection parts used to connect electrodes of batteries included in the battery assembly. The monitorer derives temperatures of the batteries on the basis of the temperatures measured by the temperature measuring part.

[Brief Description of Drawings]

Fig. 1 is an exploded perspective view showing an overall constitution of a battery assembly system 1 related to a first embodiment.
Fig. 2 is a view illustrating one battery 10.
Fig. 3 is a top view of a battery assembly 5.
Fig. 4 is a cross-sectional view illustrating one example of a positional relationship among a bus bar 20, a screw 32, and a temperature sensor 34.
Fig. 5 is a simplified diagram of a constitution of the battery assembly system 1.
Fig. 6 is a view illustrating a constitution showing some of constituent elements provided at a control board 30 related to a third embodiment.
Fig. 7 is a view illustrating a constitution showing some of constituent elements provided at the control board 30 related to a fourth embodiment.
Fig. 8 is a view simply illustrating an influence of a temperature rise.

[Description of Embodiments]

Hereinafter, a battery assembly system and a control board of a battery assembly in an embodiment will be described with reference to the drawings.

(First embodiment)

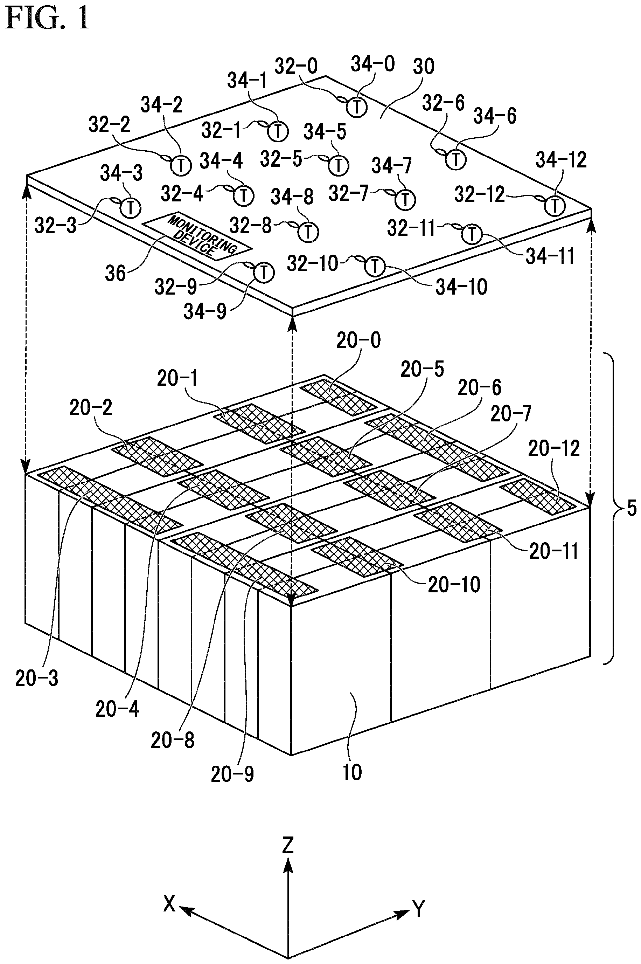

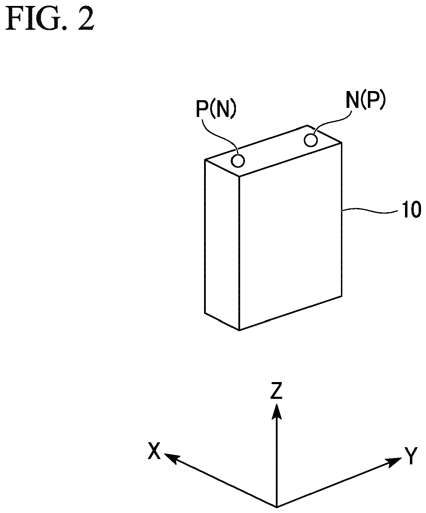

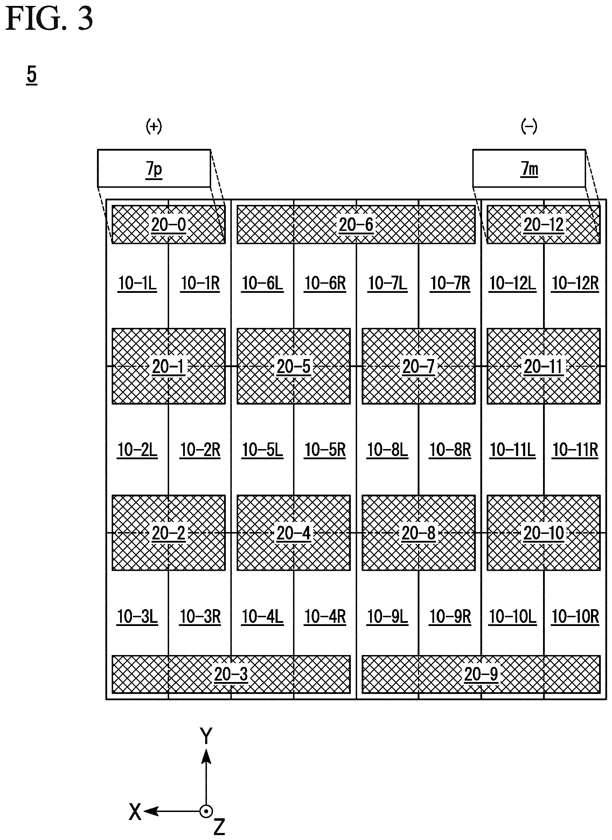

Fig. 1 is an exploded perspective view showing an overall constitution of a battery assembly system 1 related to a first embodiment. Furthermore, Fig. 2 is a view illustrating one battery 10. Fig. 3 is a top view of a battery assembly 5 (only one positive electrode 7p and one negative electrode 7m of the entire battery assembly 5 are illustrated as in a bird's eye view).

The battery assembly system 1 includes, for example, the battery assembly 5 including batteries (cells) 10-1L and 10-1R to 10-12L and 10-12R and a control board 30. Batteries, in which numbers after hyphens are the same and letter parts after the hyphens such as L and R differ, are connected in parallel with each other and used such as a battery 10-1L and a battery 10-1R and a battery 10-2L and a battery 10-2R in the battery assembly 5. Hereinafter, when batteries need not be distinguished from each other, they are referred to simply as batteries 10.

The batteries 10 are, for example, preferably lithium ion batteries in which manganese is used for a positive electrode and lithium titanate is used for a negative electrode. A rate of receiving charge can be improved and a likelihood of an internal short circuit being caused due to precipitation of lithium can be decreased by adopting such a configuration for the batteries 10. In the case of the batteries 10, a plurality of structures, in which positive electrodes and negative electrodes face each other with separators interposed therebetween, are stacked, and as shown in Fig. 2, a positive electrode terminal P connected to the plurality of positive electrodes, a negative electrode terminal N connected to the plurality of negative electrodes, and a gas exhaust valve are provided at a casing surface. Furthermore, each of the batteries 10 may be a lithium ion battery in which a lithium metal oxide is used for each of the positive electrodes and a carbon material such as graphite is used for each of the negative electrodes, and may be a battery of another aspect such as a lead storage battery.

The batteries 10 are connected to each other using bus bars (connection parts). A bus bar 20-0 connects the positive electrode 7p (a voltage taking-out part at the positive electrode) for the entire battery assembly 5 and positive electrodes of the battery 10-1L and the battery 10-1R. A bus bar 20-1 connects negative electrodes of the battery 10-1L and the battery 10-1R and positive electrodes of the battery 10-2L and the battery 10-2R. A bus bar 20-2 connects negative electrodes of the battery 10-2L and the battery 10-2R and positive electrodes of a battery 10-3L and a battery 10-3R. A bus bar 20-3 connects negative electrodes of the battery 10-3L and the battery 10-3R and positive electrodes of a battery 10-4L and a battery 10-4R. A bus bar 20-4 connects negative electrodes of the battery 10-4L and the battery 10-4R and positive electrodes of a battery 10-5L and a battery 10-5R. A bus bar 20-5 connects negative electrodes of the battery 10-5L and the battery 10-5R and positive electrodes of a battery 10-6L and a battery 10-6R. A bus bar 20-6 connects negative electrodes of the battery 10-6L and the battery 10-6R and positive electrodes of a battery 10-7L and a battery 10-7R. A bus bar 20-7 connects negative electrodes of the battery 10-7L and the battery 10-7R and positive electrodes of a battery 10-8L and a battery 10-8R. A bus bar 20-8 connects negative electrodes of the battery 10-8L and the battery 10-8R and positive electrodes of a battery 10-9L and a battery 10-9R. A bus bar 20-9 connects negative electrodes of the battery 10-9L and the battery 10-9R and positive electrodes of a battery 10-10L and a battery 10-10R. A bus bar 20-10 connects negative electrodes of the battery 10-10L and the battery 10-10R and positive electrodes of a battery 10-11 L and a battery 10-11 R. A bus bar 20-11 connects negative electrodes of the battery 10-11L and the battery 10-11R and positive electrodes of a battery 10-12L and a battery 10-12R. A bus bar 20-12 connects negative electrodes of the battery 10-12L and the battery 10-12R and the negative electrode 7m (a voltage taking-out part at the negative electrode) for the entire battery assembly 5. With such a connection structure, the battery assembly 5 is constituted as a battery assembly in which 2 batteries are in parallel and 12 batteries are in series. Hereinafter, when the bus bars need not be distinguished from each other, they are referred to simply as bus bars 20.

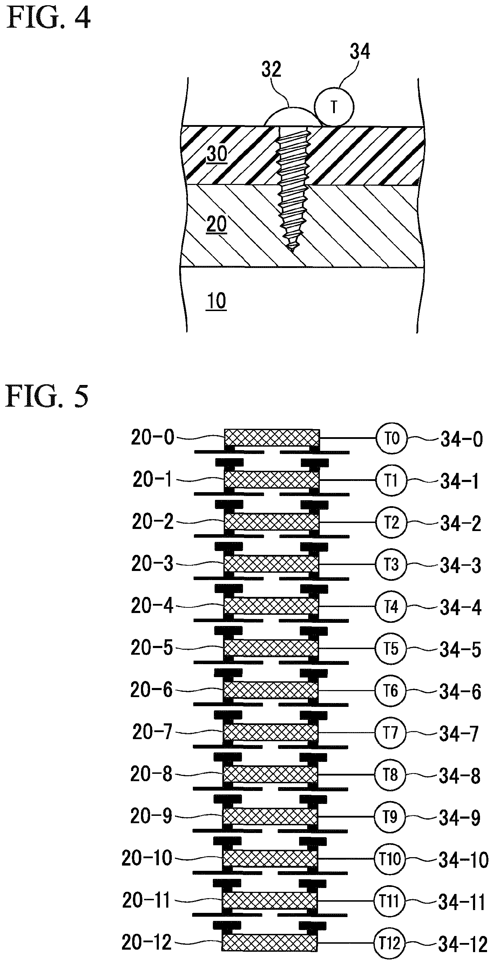

For example, the bus bars 20-0 to 20-12 are secured to the control board 30 using screws (or bolts or the like) 32-0 to 32-12. Temperature sensors 34-0 to 34-12 are attached to the screws 32-0 to 32-12 as a temperature measuring part. Hereinafter, when the screws and the temperature sensors need not be distinguished from each other, they are referred to simply as screws 32 and temperature sensors 34, respectively. Fig. 4 is a cross-sectional view illustrating one example of a positional relationship among one of the bus bars 20, one of the screws 32, and one of the temperature sensors 34. With such a structure, the temperature sensor 34 measures a temperature transferred via the screw 32 from the bus bar 20, that is, a temperature which can be regarded as a temperature of the bus bar 20, and outputs measurement results to a monitoring device 36. Note that the positional relationship shown in Fig. 4 is merely one example and the temperatures of the bus bars 20 may be measured using other structures.

The monitoring device 36 is, for example, a microcomputer. Information of temperatures measured by the temperature sensors 34 is input to the monitoring device 36. The monitoring device 36 derives temperatures of the batteries 10 on the basis of the temperatures measured by the temperature sensors 34.

Hereinafter, a temperature monitoring method using the monitoring device 36 will be described. Fig. 5 is a simplified diagram of a constitution of the battery assembly system 1. Hereinafter, a temperature measured by a temperature sensor 34-k (k = 0 to 12) is referred to as Tk (k = 0 to 12). Here, if it is estimated that a temperature of the positive electrode 7p in the battery assembly 5 is Ttp, a temperature of the negative electrode 7m is Ttm, an average temperature of a battery 10-nL and a battery 10-nR (n = 1 to 12) is Tcn, and the bus bar 20 has a temperature in which a temperature of the battery 10 connected to the bus bar 20 is uniformly reflected in the bus bar 20, it is presumed that the following simultaneous equations are established.

$$T0 = 0.5 \times (Ttp + Tc1)$$

$$T1 = 0.5 \times (Tc1 + Tc2)$$

$$T2 = 0.5 \times (Tc2 + Tc3)$$

$$T3 = 0.5 \times (Tc3 + Tc4)$$

$$T4 = 0.5 \times (Tc4 + Tc5)$$

$$T5 = 0.5 \times (Tc5 + Tc6)$$

$$T6 = 0.5 \times (Tc6 + Tc7)$$

$$T7 = 0.5 \times (Tc7 + Tc8)$$

$$T8 = 0.5 \times (Tc8 + Tc9)$$

$$T9 = 0.5 \times (Tc9 + Tc10)$$

$$T10 = 0.5 \times (Tc10 + Tc11)$$

$$T11 = 0.5 \times (Tc11 + Tc12)$$

$$T12 = 0.5 \times (Tc12 + Ttm)$$

Here, if there is no particular abnormality in the battery assembly 5, a temperature Ttp of the positive electrode 7p and a temperature Ttm of the negative electrode 7m in the battery assembly 5 depend on a current with which the battery assembly 5 is charged and which is discharged from the battery assembly 5. Thus, these temperatures can be regarded as the same. If temperature Ttp = temperature Ttm = temperature Ttave is satisfied, an unknown number in the above-described simultaneous equations is 12. Thus, the temperature Tcn can be calculated. Furthermore, the simultaneous equations can be represented by a characteristic determinant of Expression (1).
[Math. 1]

$$
\begin{pmatrix} 0.5 & 0.5 & \cdots & 0 & 0 \\ 0 & 0.5 & \cdots & 0 & 0 \\ \vdots & \vdots & \vdots & \vdots & \vdots \\ 0 & 0 & \cdots & 0.5 & 0.5 \\ 0.5 & 0 & \cdots & 0 & 0.5 \end{pmatrix} \begin{pmatrix} T_{tave} \\ T_{c1} \\ \vdots \\ T_{c11} \\ T_{c12} \end{pmatrix} = \begin{pmatrix} T_0 \\ T_1 \\ \vdots \\ T_{11} \\ T_{12} \end{pmatrix} \qquad \cdots (1)
$$

The monitoring device 36 performs an inverse matrix operation on a characteristic determinant represented by Expression (2) to calculate a temperature Ttave of the positive electrode 7p and the negative electrode 7m in the battery assembly 5 and an average temperature Tcn of the battery 10-nL and the battery 10-nR from temperatures Tk measured by the temperature sensors 34-k. The monitoring device 36 performs an inverse matrix operation by inputting the temperatures Tk measured by the temperature sensors 34-k to software information associated with the above-described inverse matrix operation already prepared in a storage device of the monitoring device 36 in a format such as, for example, a function or a table as an operand.
[Math. 2]

$$
\begin{pmatrix} T_{tave} \\ T_{c1} \\ \vdots \\ T_{c11} \\ T_{c12} \end{pmatrix} = \begin{pmatrix} 1 & -1 & 1 & -1 & 1 & -1 & 1 & -1 & 1 & -1 & 1 & -1 & 1 \\ 1 & 1 & -1 & 1 & -1 & 1 & -1 & 1 & -1 & 1 & -1 & 1 & -1 \\ -1 & 1 & 1 & -1 & 1 & -1 & 1 & -1 & 1 & -1 & 1 & -1 & 1 \\ 1 & -1 & 1 & 1 & -1 & 1 & -1 & 1 & -1 & 1 & -1 & 1 & -1 \\ -1 & 1 & -1 & 1 & 1 & -1 & 1 & -1 & 1 & -1 & 1 & -1 & 1 \\ 1 & -1 & 1 & -1 & 1 & 1 & -1 & 1 & -1 & 1 & -1 & 1 & -1 \\ -1 & 1 & -1 & 1 & -1 & 1 & 1 & -1 & 1 & -1 & 1 & -1 & 1 \\ 1 & -1 & 1 & -1 & 1 & -1 & 1 & 1 & -1 & 1 & -1 & 1 & -1 \\ -1 & 1 & -1 & 1 & -1 & 1 & -1 & 1 & 1 & -1 & 1 & -1 & 1 \\ 1 & -1 & 1 & -1 & 1 & -1 & 1 & -1 & 1 & 1 & -1 & 1 & -1 \\ -1 & 1 & -1 & 1 & -1 & 1 & -1 & 1 & -1 & 1 & 1 & -1 & 1 \\ 1 & -1 & 1 & -1 & 1 & -1 & 1 & -1 & 1 & -1 & 1 & 1 & -1 \\ -1 & 1 & -1 & 1 & -1 & 1 & -1 & 1 & -1 & 1 & -1 & 1 & 1 \end{pmatrix} \begin{pmatrix} T_0 \\ T_1 \\ \vdots \\ T_{11} \\ T_{12} \end{pmatrix} \qquad \cdots (2)
$$

Note that, when abnormality occurs in any of the temperature sensors 34, a phenomenon in which "values of Ttp and Ttm significantly differ" or a "calculated value of Tc1 or Tc12 is an abnormal value" occurs. Thus, abnormality of the temperature sensors 34 can also be detected.
According to the battery assembly system and the control board of the battery assembly, which have been described above, related to the first embodiment, the temperature sensors 34 configured to measure the temperatures of the bus bars 20 connecting the electrodes of the batteries 10 included in the battery assembly 5 and the temperatures of the bus bars 20 connecting the batteries 10 and the voltage taking-out part of the battery assembly 5, and the monitoring device 36 configured to derive the temperatures of the batteries 10 on the basis of the temperatures measured by the temperature sensors 34 are provided so that the temperatures of the batteries 10 can be derived.
Also, according to the first embodiment, an inverse matrix operation on a characteristic determinant according to temperature transfer characteristics of the battery assembly 5 is performed so that the temperatures of the batteries 10 are derived. Thus, a calculating process can be simplified, and a processing load can be reduced.
According to the first embodiment, the characteristic determinant and the inverse matrix operation thereof are used so that a temperature measurement error (an offset error) due to the temperature sensors 34 can be offset.

(Second embodiment)

Hereinafter, a battery assembly system and a control board of a battery assembly related to a second embodiment will be described. Although it is assumed that an inverse matrix operation is performed on a matrix based on Expressions (1) and (2) or the like and the temperatures Ttave and Tcn are acquired under the assumption that the bus bar 20 has a temperature at which the temperature of the battery 10 connected to the bus bar 20 is uniformly reflected into the bus bar 20 in the first embodiment, an inverse matrix operation may be performed on a matrix based on an expression in which a bias is reflected so that the temperature Ttave and Tcn are acquired when the bus bar 20 does not have the temperature at which the temperature of the battery 10 connected to the bus bar 20 is uniformly reflected into the bus bar 20 in the second embodiment.

For example, when the temperature of the bus bar 20-0 is more significantly affected by the temperature of the positive electrode 7p in the battery assembly 5 than the battery 10-1L and the battery 10-1R due to an attachment position, a size, a shape, or the like of the bus bar 20-0, a tendency thereof can be expressed in the following equation.

$$T0 = 0.7 \times Ttp + 0.3 \times Tc1$$

Similarly, when the temperatures of the bus bars 20 are significantly affected by the temperatures of some of the connected batteries 10 due to attachment positions, sizes, shapes, or the like of the bus bars 20, for example, it can be estimated that the following simultaneous equations will be established.

$$T0 = 0.7 \times Ttp + 0.3 \times Tc1$$

$$T1 = 0.6 \times Tc1 + 0.4 \times Tc2$$

$$T2 = 0.6 \times Tc2 + 0.4 \times Tc3$$

$$T3 = 0.5 \times Tc3 + 0.5 \times Tc4$$

$$T4 = 0.4 \times Tc4 + 0.6 \times Tc5$$

$$T5 = 0.4 \times Tc5 + 0.6 \times Tc6$$

$$T6 = 0.5 \times Tc6 + 0.5 \times Tc7$$

$$T7 = 0.6 \times Tc7 + 0.4 \times Tc8$$

$$T8 = 0.6 \times Tc8 + 0.4 \times Tc9$$

$$T9 = 0.5 \times Tc9 + 0.5 \times Tc10$$

$$T10 = 0.4 \times Tc10 + 0.6 \times Tc11$$

$$T11 = 0.4 \times Tc11 + 0.6 \times Tc12$$

$$T12 = 0.3 \times Tc12 + 0.7 \times Ttm$$

The monitorer 36 related to the second embodiment takes into account, for example, the above-described simultaneous equations, and the temperatures Ttave and Tcn are acquired by performing an inverse matrix operation on a characteristic determinant (3) established when Ttp = Ttm is assumed.
[Math. 3]

$$
\begin{pmatrix}
0.7 & 0.3 & \cdots & 0 & 0 \\
0 & 0.6 & \cdots & 0 & 0 \\
\vdots & \vdots & \vdots & \vdots & \vdots \\
0 & 0 & \cdots & 0.4 & 0.6 \\
0.7 & 0 & \cdots & 0 & 0.3
\end{pmatrix}
\begin{pmatrix}
T_{tave} \\
T_{c1} \\
\vdots \\
T_{c11} \\
T_{c12}
\end{pmatrix}
=
\begin{pmatrix}
T_0 \\
T_1 \\
\vdots \\
T_{11} \\
T_{12}
\end{pmatrix}
\quad \cdots(3)
$$

Note that, when a serial number is 4, the characteristic determinant is represented by, for example, Expression (4). An inverse matrix of a characteristic determinant (4) is represented by Expression (5).
[Math. 4]

$$
\begin{pmatrix}
0.6 & 0.4 & 0 & 0 & 0 \\
0 & 0.6 & 0.4 & 0 & 0 \\
0 & 0 & 0.6 & 0.4 & 0 \\
0 & 0 & 0 & 0.6 & 0.4 \\
0.4 & 0 & 0 & 0 & 0.6
\end{pmatrix}
\begin{pmatrix}
T_{tave} \\
T_{c1} \\
T_{c2} \\
T_{c3} \\
T_{c4}
\end{pmatrix}
=
\begin{pmatrix}
T_0 \\
T_1 \\
T_2 \\
T_3 \\
T_4
\end{pmatrix}
\quad \cdots(4)
$$

$$
\begin{pmatrix}
T_{tave} \\
T_{c1} \\
T_{c2} \\
T_{c3} \\
T_{c4}
\end{pmatrix}
=
\begin{pmatrix}
1.472 & -0.982 & 0.655 & -0.436 & 0.291 \\
0.291 & 1.472 & -0.982 & 0.655 & -0.436 \\
-0.436 & 0.291 & 1.472 & -0.982 & 0.655 \\
0.655 & -0.436 & 0.291 & 1.472 & -0.982 \\
-0.982 & 0.655 & -0.436 & 0.291 & 1.472
\end{pmatrix}
\begin{pmatrix}
T_0 \\
T_1 \\
T_2 \\
T_3 \\
T_4
\end{pmatrix}
\quad \cdots(5)
$$

According to the battery assembly system and the control board of the battery assembly, which have been described above, related to the second embodiment, the temperatures of the batteries 10 can be derived as in the first embodiment. Furthermore, according to the second embodiment, the temperatures of the batteries 10 can be appropriately derived even when the bus bar 20 does not have a temperature at which the temperature of the battery 10 connected to the bus bar 20 is uniformly reflected into the bus bar 20.

(Third embodiment)

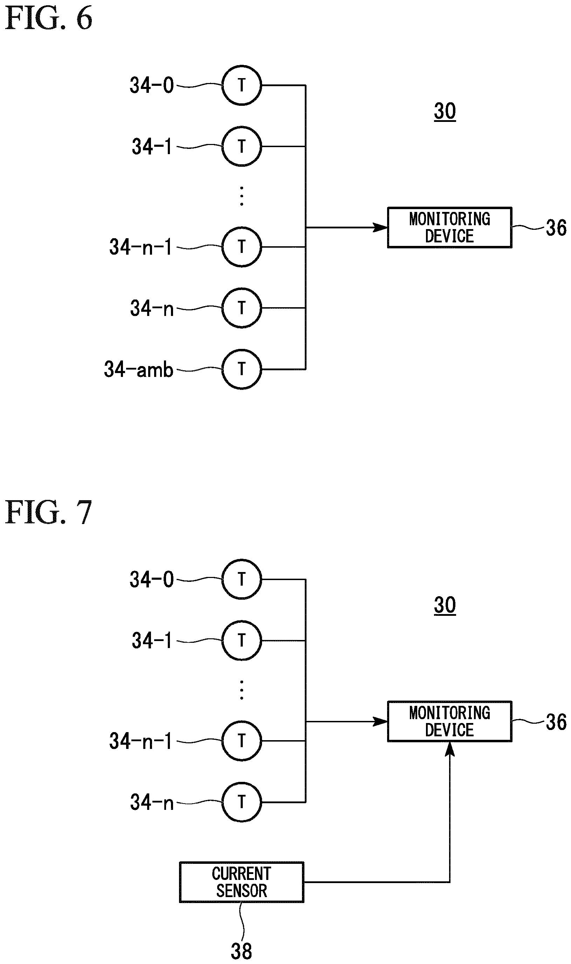

Hereinafter, a battery assembly system and a control board of a battery assembly related to a third embodiment will be described. In the third embodiment, a temperature sensor configured to measure a board temperature is provided, and temperatures of the batteries 10 are derived from temperatures measured by the temperature sensor are derived. Fig. 6 is a view illustrating a constitution showing some of constituent elements provided at a control board 30 related to the third embodiment. As shown in the drawing, in the case of the control board 30, a temperature sensor 34-amb configured to measure a temperature of the control board 30 is attached to any place in addition to temperature sensors 34-0 to 34-n (n is a serial number) as in the first or second embodiments. The temperature sensor 34-amb measures the temperature of the control board 30 and outputs measurement results to a monitoring device 36.

In this embodiment, when the bus bar 20 has the temperature at which the temperature of the battery 10 connected to the bus bar 20 is uniformly reflected into the bus bar 20 as in the first embodiment, the following simultaneous equations are estimated to be established. In the expression, $\alpha 1$ and $\alpha 2$ are coefficients obtained through experiments or the like, and for example, are set such that $\alpha 1 + \alpha 2 = 1$ is satisfied.

$$T0 = \alpha 1 \times 0.5 \times (Ttp + Tc1) + \alpha 2 \times Tamb$$

$$T1 = \alpha 1 \times 0.5 \times (Tc1 + Tc2) + \alpha 2 \times Tamb$$

$$..$$

$$Tn - 1 = \alpha 1 \times 0.5 \times (Tc(n - 1) + Tcn) + \alpha 2 \times Tamb$$

$$Tn = \alpha 1 \times 0.5 \times (Tcn + Ttm) + \alpha 2 \times Tamb$$

In this case, the characteristic determinant is represented by, for example, Expression (6). The monitorer 36 related to the third embodiment performs, for example, an inverse matrix operation of a characteristic determinant (6) to acquire temperatures Ttave and Tcn.
[Math. 5]

$$\alpha 1 \begin{pmatrix} 0.5 & 0.5 & \cdots & 0 & 0 \\ 0 & 0.5 & \cdots & 0 & 0 \\ \vdots & \vdots & \vdots & \vdots & \vdots \\ 0 & 0 & \cdots & 0.5 & 0.5 \\ 0.5 & 0 & \cdots & 0 & 0.5 \end{pmatrix} \begin{pmatrix} T_{tave} \\ T_{c1} \\ \vdots \\ T_{c11} \\ T_{c12} \end{pmatrix} + \alpha 2 \begin{pmatrix} T_{amb} \\ T_{amb} \\ \vdots \\ T_{amb} \\ T_{amb} \end{pmatrix} = \begin{pmatrix} T_0 \\ T_1 \\ \vdots \\ T_{11} \\ T_{12} \end{pmatrix} \quad \cdots (6)$$

Note that an influence on the batteries 10 due to the temperature of the control board 30 is not uniform, and may be different for each battery 10. If the influence on the batteries 10 due to the temperature of the control board 30 varies when the serial number is 4, the characteristic determinant is represented by, for example, Expression (7). An inverse matrix in this case is represented by Expression (8).
[Math. 6]

$$\begin{pmatrix} 0.4 & 0.4 & 0 & 0 & 0 \\ 0 & 0.4 & 0.3 & 0 & 0 \\ 0 & 0 & 0.4 & 0.3 & 0 \\ 0 & 0 & 0 & 0.4 & 0.4 \\ 0.4 & 0 & 0 & 0 & 0.4 \end{pmatrix} \begin{pmatrix} T_{tave} \\ T_{c1} \\ T_{c2} \\ T_{c3} \\ T_{c4} \end{pmatrix} + \begin{pmatrix} 0.2 \\ 0.3 \\ 0.3 \\ 0.2 \\ 0.2 \end{pmatrix} T_{tamb} = \begin{pmatrix} T_0 \\ T_1 \\ T_2 \\ T_3 \\ T_4 \end{pmatrix} \quad \cdots (7)$$

$$\begin{pmatrix} T_{tave} \\ T_{c1} \\ T_{c2} \\ T_{c3} \\ T_{c4} \end{pmatrix} = \begin{pmatrix} 1.6 & -1.6 & 1.2 & -0.9 & 0.9 \\ 0.9 & 1.6 & -1.2 & 0.9 & -0.9 \\ -1.2 & 1.2 & 1.6 & -1.2 & 1.2 \\ 1.6 & -1.6 & 1.2 & 1.6 & -1.6 \\ -1.6 & 1.6 & -1.2 & 0.291 & 1.6 \end{pmatrix} \begin{pmatrix} T_0 \\ T_1 \\ T_2 \\ T_3 \\ T_4 \end{pmatrix} - \begin{pmatrix} 0.2 \\ 0.3 \\ 0.6 \\ 0.2 \\ 0.2 \end{pmatrix} T_{tamb} \quad \cdots (8)$$

According to the battery assembly system and the control board of the battery assembly, which have been described above, related to the third embodiment, the temperatures of the batteries 10 can be derived as in the first embodiment. Furthermore, according to the third embodiment, the influence due to the temperature of the control board 30 is subtracted so that the temperatures of the batteries 10 are derived. Thus, the temperatures of the batteries 10 can be more accurately derived.

(Fourth embodiment)

Hereinafter, a battery assembly system and a control board of a battery assembly related to a fourth embodiment will be described. In the fourth embodiment, temperatures of batteries 10 as well as an assumed generated heat value due to a current flowing through bus bars 20 are derived.

Fig. 7 is a view illustrating a constitution showing some of constituent elements provided at a control board 30 related to the fourth embodiment. A current sensor (a current detector) 38 is provided at any place on a power path connected to a positive electrode 7p or a negative electrode 7m of a battery assembly 5. Note that the current sensor 38 may be provided at other places which are not on the control board 30. The current sensor 38 detects a current value with which the battery assembly 5 is charged and which is discharged from the battery assembly 5, and outputs detection results to the monitoring device 36.

In this embodiment, when it is assumed that a current flowing through the bus bars 20 is I and the bus bars 20 have temperatures in which temperatures of the batteries 10 connected to the bus bars 20 are uniformly reflected into the bus bars 20 as in the first embodiment, the following simultaneous equations are estimated to be established. In the expressions, $\beta 0$ to $\beta n$ are coefficients based on a resistance value for each bus bar 20, and R is a reference resistance value.

$$T0 = 0.5 \times (Ttp + Tc1) + \beta 0 \times I2 \times R$$

$$T1 = 0.5 \times (Tc1 + Tc2) + \beta 1 \times I2 \times R$$

$$..$$

$$Tn - 1 = 0.5 \times (Tc(n - 1) + Tcn) + \beta(n - 1) \times I2 \times R$$

$$Tn = 0.5 \times (Tcn + Ttm) + \beta n \times I2 \times R$$

In the case, a characteristic determinant is represented by, for example, Expression (9). The monitoring device 36 related to the third embodiment acquires temperatures Ttave and Tcn, for example, by performing an inverse matrix operation on a characteristic determinant (9).

[Math. 7]

$$\begin{pmatrix} 0.5 & 0.5 & \cdots & 0 & 0 \\ 0 & 0.5 & \cdots & 0 & 0 \\ \vdots & \vdots & \vdots & \vdots & \vdots \\ 0 & 0 & \cdots & 0.5 & 0.5 \\ 0.5 & 0 & \cdots & 0 & 0.5 \end{pmatrix} \begin{pmatrix} T_{tave} \\ T_{c1} \\ \vdots \\ T_{c11} \\ T_{c12} \end{pmatrix} + \begin{pmatrix} \beta_0 \\ \beta_1 \\ \vdots \\ \beta_{11} \\ \beta_{12} \end{pmatrix} I^2 \cdot R = \begin{pmatrix} T_0 \\ T_1 \\ \vdots \\ T_{11} \\ T_{12} \end{pmatrix} \quad \cdots(9)$$

Note that, when a serial number is 4, the characteristic determinant is represented by, for example, Expression (10). An inverse matrix of a characteristic determinant (10) is represented by Expression (11).

[Math. 8]

$$\begin{pmatrix} 0.5 & 0.5 & 0 & 0 & 0 \\ 0 & 0.5 & 0.5 & 0 & 0 \\ 0 & 0 & 0.5 & 0.5 & 0 \\ 0 & 0 & 0 & 0.5 & 0.5 \\ 0.5 & 0 & 0 & 0 & 0.5 \end{pmatrix} \begin{pmatrix} T_{tave} \\ T_{c1} \\ T_{c2} \\ T_{c3} \\ T_{c4} \end{pmatrix} + \begin{pmatrix} 0.3 \\ 0.2 \\ 0.2 \\ 0.2 \\ 0.3 \end{pmatrix} I^2 \cdot R = \begin{pmatrix} T_0 \\ T_1 \\ T_2 \\ T_3 \\ T_4 \end{pmatrix} \quad \cdots(10)$$

$$\begin{pmatrix} T_{tave} \\ T_{c1} \\ T_{c2} \\ T_{c3} \\ T_{c4} \end{pmatrix} = \begin{pmatrix} 1 & -1 & 1 & -1 & 1 \\ 1 & 1 & -1 & 1 & -1 \\ -1 & 1 & 1 & -1 & 1 \\ 1 & -1 & 1 & 1 & -1 \\ -1 & 1 & -1 & 1 & 1 \end{pmatrix} \begin{pmatrix} T_0 \\ T_1 \\ T_2 \\ T_3 \\ T_4 \end{pmatrix} - \begin{pmatrix} 0.4 \\ 0.2 \\ 0.2 \\ 0.2 \\ 0.2 \end{pmatrix} I^2 \cdot R \quad \cdots(11)$$

According to the battery assembly system and the control board of the battery assembly, which have been described above, related to the fourth embodiment, the temperatures of the batteries 10 can be derived as in the first embodiment. Furthermore, according to the fourth embodiment, an influence given to the temperature of the batteries 10 by a current value with which the battery assembly 5 is charged and which is discharged from the battery assembly 5 is added so that the temperatures of the batteries 10 are derived. Thus, the temperatures of the batteries 10 can be more accurately derived.

(Fifth embodiment)

Hereinafter, a battery assembly system and a control board of a battery assembly related to a fifth embodiment will be described. In the fifth embodiment, temperatures of batteries 10 as well as resistance values of balance resistors for suppressing a variation of voltages of the batteries 10 are derived. The balance resistors are provided, for example, on a control board 30. Furthermore, a disposition and resistance values of the balance resistors are known, and are stored in a storage device of a monitoring device 36.

In this embodiment, when bus bars 20 have temperatures in which temperatures of the batteries 10 connected to the bus bars 20 are uniformly reflected into the bus bars 20 as in the first embodiment, the following simultaneous equations are estimated to be established. In the expression, $\gamma 0$ to $\gamma n$ are coefficients of an influence on bus bar temperature due to balance discharge, and Ncell is the number of the batteries 10 in which balance discharge is performed

$$\mathrm{T0} = 0.5 \times (\mathrm{Ttp} + \mathrm{Tc1}) + \gamma 0$$

$$\mathrm{T0} = 0.5 \times (\mathrm{Ttp} + \mathrm{Tc1}) + \gamma 0$$

$$\mathrm{T1} = 0.5 \times (\mathrm{Tc1} + \mathrm{Tc2}) + \gamma 1$$

$$..$$

$$\mathrm{Tn} - 1 = 0.5 \times (\mathrm{Tc(n-1)} + \mathrm{Tcn}) + \gamma (n-1)$$

$$\mathrm{Tn} = 0.5 \times (\mathrm{Tcn} + \mathrm{Ttm}) + \gamma n$$

In this case, a characteristic determinant is represented by, for example, Expression (12). The monitoring device 36 related to the fifth embodiment acquires temperatures Ttave and Tcn, for example, by performing an inverse matrix operation on a characteristic determinant (12).
[Math. 9]

$$\begin{pmatrix} 0.5 & 0.5 & \cdots & 0 & 0 \\ 0 & 0.5 & \cdots & 0 & 0 \\ \vdots & \vdots & \vdots & \vdots & \vdots \\ 0 & 0 & \cdots & 0.5 & 0.5 \\ 0.5 & 0 & \cdots & 0 & 0.5 \end{pmatrix} \begin{pmatrix} T_{tave} \\ T_{c1} \\ \vdots \\ T_{c11} \\ T_{c12} \end{pmatrix} + \begin{pmatrix} \gamma_0 \\ \gamma_1 \\ \vdots \\ \gamma_{11} \\ \gamma_{12} \end{pmatrix} = \begin{pmatrix} T_0 \\ T_1 \\ \vdots \\ T_{11} \\ T_{12} \end{pmatrix} \quad \cdots (12)$$

Note that, when a serial number is 4, the characteristic determinant is represented by, for example, Expression (13). An inverse matrix of a characteristic determinant (13) is represented by Expression (14).
[Math. 10]

$$\begin{pmatrix} 0.5 & 0.5 & 0 & 0 & 0 \\ 0 & 0.5 & 0.5 & 0 & 0 \\ 0 & 0 & 0.5 & 0.5 & 0 \\ 0 & 0 & 0 & 0.5 & 0.5 \\ 0.5 & 0 & 0 & 0 & 0.5 \end{pmatrix} \begin{pmatrix} T_{tave} \\ T_{c1} \\ T_{c2} \\ T_{c3} \\ T_{c4} \end{pmatrix} + \begin{pmatrix} 0.3 \\ 0.2 \\ 0.2 \\ 0.2 \\ 0.3 \end{pmatrix} N_{cell} = \begin{pmatrix} T_0 \\ T_1 \\ T_2 \\ T_3 \\ T_4 \end{pmatrix} \quad \cdots(13)$$

$$\begin{pmatrix} T_{tave} \\ T_{c1} \\ T_{c2} \\ T_{c3} \\ T_{c4} \end{pmatrix} = \begin{pmatrix} 1 & -1 & 1 & -1 & 1 \\ 1 & 1 & -1 & 1 & -1 \\ -1 & 1 & 1 & -1 & 1 \\ 1 & -1 & 1 & 1 & -1 \\ -1 & 1 & -1 & 1 & 1 \end{pmatrix} \begin{pmatrix} T_0 \\ T_1 \\ T_2 \\ T_3 \\ T_4 \end{pmatrix} - \begin{pmatrix} 0.4 \\ 0.2 \\ 0.2 \\ 0.2 \\ 0.2 \end{pmatrix} N_{cell} \quad \cdots(14)$$

Also, in the above-described example, a case in which balance discharge circuits are partially fixed is assumed, and calculation is performed in proportion to the number of cells to be discharged. Here, when the balance discharge circuits are distributed in an entire circuit, an influence of discharge can also be checked for each bus bar 20. For example, when discharging parts are distributed, the balance resistors influence the bus bars 20 as a matrix so that the temperatures Ttave and Tcn can be acquired. A characteristic determinant in this case is represented by, for example, Expression (15). Furthermore, an inverse matrix of a characteristic determinant (15) is represented by Expression (16).
[Math. 11]

$$\begin{pmatrix} 0.5 & 0.5 & 0 & 0 & 0 \\ 0 & 0.5 & 0.5 & 0 & 0 \\ 0 & 0 & 0.5 & 0.5 & 0 \\ 0 & 0 & 0 & 0.5 & 0.5 \\ 0.5 & 0 & 0 & 0 & 0.5 \end{pmatrix} \begin{pmatrix} T_{tave} \\ T_{c1} \\ T_{c2} \\ T_{c3} \\ T_{c4} \end{pmatrix} + \begin{pmatrix} 0.1 & 0.1 & 0 & 0 & 0 \\ 0 & 0.1 & 0 & 0 & 0 \\ 0 & 0 & 0.1 & 0 & 0 \\ 0 & 0 & 0 & 0.1 & 0 \\ 0 & 0 & 0.1 & 0 & 0 \end{pmatrix} \begin{pmatrix} N_1 \\ N_2 \\ N_3 \\ N_4 \\ 0 \end{pmatrix} = \begin{pmatrix} T_0 \\ T_1 \\ T_2 \\ T_3 \\ T_4 \end{pmatrix} \quad \cdots(15)$$

$$\begin{pmatrix} T_{tave} \\ T_{c1} \\ T_{c2} \\ T_{c3} \\ T_{c4} \end{pmatrix} = \begin{pmatrix} 1 & -1 & 1 & -1 & 1 \\ 1 & 1 & -1 & 1 & -1 \\ -1 & 1 & 1 & -1 & 1 \\ 1 & -1 & 1 & 1 & -1 \\ -1 & 1 & -1 & 1 & 1 \end{pmatrix} \begin{pmatrix} T_0 \\ T_1 \\ T_2 \\ T_3 \\ T_4 \end{pmatrix} - \begin{pmatrix} 0.1 & 0 & 0.2 & -0.1 & 0 \\ 0 & 0.2 & -0.2 & 0.1 & 0 \\ -0.1 & 0 & 0.2 & -0.1 & 0 \\ 0.1 & 0 & 0 & 0.1 & 0 \\ -0.1 & 0 & 0 & 0.1 & 0 \end{pmatrix} \begin{pmatrix} N_1 \\ N_2 \\ N_3 \\ N_4 \\ 0 \end{pmatrix} \quad \cdots(16)$$

According to the battery assembly system and the control board of the battery assembly, which have been described above, related to the fifth embodiment, the temperatures of the batteries 10 can be derived as in the first embodiment. Furthermore, according to the fifth embodiment, the temperatures of the batteries 10 are derived by subtracting the influence due to the balance resistors. Thus, the temperatures of the batteries 10 can be more accurately derived.

(Sixth embodiment)

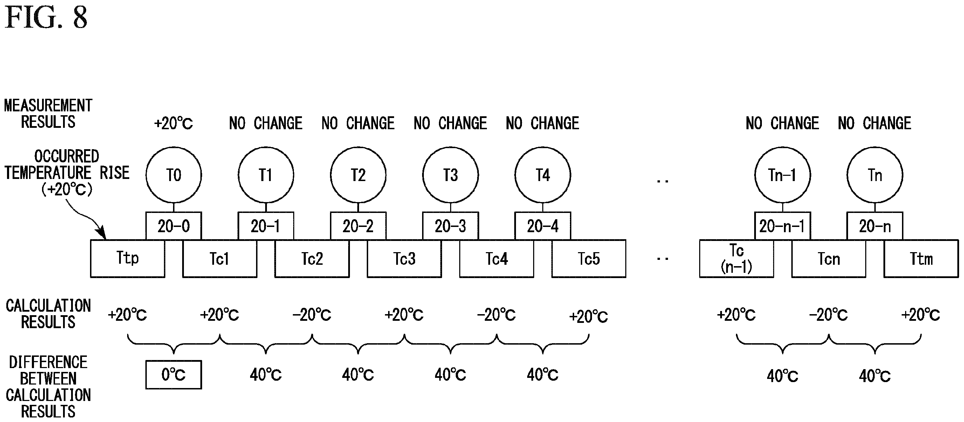

Hereinafter, a battery assembly system and a control board of a battery assembly related to a sixth embodiment will be described. In the sixth embodiment, a positive electrode 7p and a negative electrode 7m of a battery assembly 5 serve as temperature monitoring targets and a temperature monitoring target in which an abnormality has occurred among batteries 10 is extracted on the basis of a difference between temperatures calculated with respect to temperature monitoring targets which are adjacent to each other. In the first to fifth embodiments, the processes are performed under the assumption that temperatures of the positive electrode 7p and the negative electrode 7m of the battery assembly 5 are the same, but in the sixth embodiment, it can be determined whether abnormality occurs in any of the positive electrode 7p and the negative electrode 7m of the battery assembly 5.
An inverse matrix of Expression (2) will be described as an example. For example, when a temperature of the positive electrode 7p of the battery assembly 5 rises due to loosening of a terminal or the like, this temperature rise appears as a temperature rise of a bus bar 20-0. In this case, according to Expression (2), temperatures Ttave and Tc1 both increase, however, other than the relation of the temperatures Ttave and Tc1, alternating opposite effects appear such as a temperature Tc2 decreasing, a temperature Tc3 increasing, a temperature Tc4 decreasing, and a temperature Tc5 increasing. Fig. 8 is a view simply illustrating an influence of a temperature rise. In an example of Fig. 8, it is assumed that a temperature Ttp of the positive electrode 7p in the battery assembly 5 increases 20 °C. An inverse matrix of a characteristic determinant has characteristics in which a positive value or a negative value alternately appears in each row. Thus, as shown in Fig. 8, in the case of calculation results, a result value with a positive influence and a result value with a negative influence alternately appear with respect to a change in temperature. Also, the fact that the positive and negative influence not appearing is limited to calculation results in the vicinity of a position at which a change in temperature occurs. In the example of Fig. 8, only a difference between temperatures Ttp and Tc1 serving as a calculation result does not cause a difference between neighboring calculation results. A monitoring device 36 related to the sixth embodiment extracts temperatures Ttp and Tc1 in which a difference does not occur between neighboring calculation results, and determines that there is abnormality in any of the positive electrode 7p, the bus bar 20-0, batteries 10-1 L, and 10-1 R in the battery assembly 5 involved in the extracted temperatures. The monitoring device 36 transmits a signal used to display a place for which there is determined to be an abnormality to, for example, a display device (not shown) in a wired or wireless manner.

According to the battery assembly system and the control board of the battery assembly, which have been described above, related to the sixth embodiment, a place at which abnormality occurs can be appropriately extracted, and support is performed so that abnormality can be found early.


(Other embodiments)


The above-described processes of the embodiments can be appropriately combined. For example, in the third embodiment, calculation corresponding to a case in which a bus bar 20 does not have a temperature in which a temperature of a battery 10 connected to the bus bar 20 is uniformly reflected in the bus bar 20 may be performed as in the second embodiment. Furthermore, the process related to the sixth embodiment can be applied to the processes of the second to fifth embodiments as well as that of the first embodiment.

Also, a monitoring device 36 may decrease monitoring resolution so that a process transitions to a rough monitoring process when abnormality occurs in any of the temperature sensors 34.

According to at least one embodiment described above, a battery assembly 5 in which a plurality of batteries 10 are connected in series, temperature sensors 34 configured to measure temperatures of connection parts 20 used to connect electrodes of the batteries 10 are included in the battery assembly 5, and a monitoring device 36 is configured to derive temperatures of the batteries 10 on the basis of the temperatures measured by the temperature sensors 34 is provided so that the temperatures of the batteries 10 constituting the battery assembly 5 can be derived.

Although some embodiments of the present invention have been described, these embodiments are presented as examples, and are not intended to limit the scope of the present invention. These embodiments can be carried out in various other forms. In addition, various omissions, substitutions, or changes can be performed without departing from the gist of the present invention. These embodiments and modifications thereof are included in the scope or the gist of the present invention and are included in the scope of the appended claims and the equivalent scope thereof.


**Claims**

1.  A battery assembly system comprising:

    a battery assembly in which a plurality of batteries are connected in series;
    a temperature measuring part configured to measure temperatures of connection parts used to connect electrodes of batteries included in the battery assembly; and
    a monitoring device configured to derive temperatures of the batteries on the basis of the temperatures measured by the temperature measuring part.

2.  The battery assembly system according to claim 1, wherein the measuring part further measures temperatures of connection parts used to connect the batteries included in the battery assembly and a voltage taking-out part of the battery assembly.

3.  The battery assembly system according to claim 1 or 2, wherein the monitoring device solves simultaneous equations based on an extent to which the connection parts have temperatures in which the temperatures of the batteries connected to the connection parts or the temperature of the voltage taking-out part of the battery assembly is reflected in the connection parts to derive temperatures of the batteries.

4. The battery assembly system according to claim 3, wherein the monitoring device performs an inverse matrix operation when the simultaneous equations are set as a determinant to derive temperatures of the batteries.

5. The battery assembly system according to claim 1, wherein the temperature measuring part is provided on a control board attached to the battery assembly and further measures a temperature of the control board, and
the monitoring device subtracts a value based on the temperature of the control board measured by the temperature measuring part to derive temperatures of the batteries.

6. The battery assembly system to claim 1, comprising:

a current detector configured to detect a current with which the battery assembly is charged and which is discharged from the battery assembly,
wherein the monitoring device adds values obtained by multiplying currents detected by the current detector by resistance values of the batteries to derive temperatures of the batteries.

7. The battery assembly system to claim 1, wherein the monitoring device extracts a place at which a difference between results for batteries connected in series and adjacent to each other in the battery assembly is small among results in which the temperatures of the batteries are derived, and determines that abnormality occurs in a battery associated with the extracted place.

8. A control board of a battery assembly attached to a battery assembly in which a plurality of batteries are connected in series, the control board of the battery assembly comprising:

a temperature measuring part configured to measure temperatures of connection parts used to connect electrodes of batteries included in the battery assembly; and
a monitoring device configured to derive temperatures of the batteries on the basis of the temperatures measured by the temperature measuring part.

# FIG. 1

FIG. 2

# FIG. 3

5

FIG. 4

FIG. 5

# FIG. 6

34-0 — T
34-1 — T
⋮
34-n-1 — T
34-n — T
34-amb — T

→ MONITORING DEVICE — 36

30

# FIG. 7

34-0 — T
34-1 — T
⋮
34-n-1 — T
34-n — T

→ MONITORING DEVICE — 36

30

CURRENT SENSOR

38

# FIG. 8

EP 3 171 447 A1

**EP 3 171 447 A1**

<table>
<tr><td colspan="2" style="text-align:center"><strong>INTERNATIONAL SEARCH REPORT</strong></td><td>International application No.<br>PCT/JP2015/061351</td></tr>
</table>

A. CLASSIFICATION OF SUBJECT MATTER
*H01M10/48(2006.01)i, G01R31/36(2006.01)i*

According to International Patent Classification (IPC) or to both national classification and IPC

B. FIELDS SEARCHED

Minimum documentation searched (classification system followed by classification symbols)
H01M10/48, G01R31/36

Documentation searched other than minimum documentation to the extent that such documents are included in the fields searched
Jitsuyo Shinan Koho          1922–1996   Jitsuyo Shinan Toroku Koho   1996–2015
Kokai Jitsuyo Shinan Koho    1971–2015   Toroku Jitsuyo Shinan Koho   1994–2015

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2013-137905 A  (Aisan Industry Co., Ltd.),<br>11 July 2013 (11.07.2013),<br>paragraphs [0012] to [0034]; fig. 1, 2<br>(Family: none) | 1,2,8<br>3,4,6<br>5,7 |
| Y<br>A | JP 2011-232083 A  (Komatsu Ltd.),<br>17 November 2011 (17.11.2011),<br>paragraphs [0059] to [0066]; fig. 2, 3<br>(Family: none) | 3,4,6<br>5,7 |
| A | US 2011/0298472 A1  (Steve CARNER),<br>08 December 2011 (08.12.2011),<br>paragraph [0014]<br>& WO 2011/154856 A2     & EP 2577331 A2 | 1-8 |

☒ Further documents are listed in the continuation of Box C.      ☐ See patent family annex.

| | |
|---|---|
| *    Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>29 May 2015 (29.05.15) | Date of mailing of the international search report<br>09 June 2015 (09.06.15) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (July 2009)

20

**INTERNATIONAL SEARCH REPORT**

International application No.

PCT/JP2015/061351

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2013-206656 A  (Mitsubishi Motors Corp.), 07 October 2013 (07.10.2013), paragraphs [0024] to [0030] (Family: none) | 1-8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2010220323 A